Europäisches Patentamt

European Patent Office

Office européen des brevets

(11) Publication number: **0 051 500**
**B1**

(12) EUROPEAN PATENT SPECIFICATION

(45) Date of publication of patent specification: **19.02.86**

(51) Int. Cl.⁴: **H 01 L 29/04, H 01 L 23/52**

(21) Application number: **81305257.8**

(22) Date of filing: **05.11.81**

(54) Semiconductor devices.

(30) Priority: **05.11.80 JP 155376/80**
**07.11.80 JP 156558/80**

(43) Date of publication of application:
**12.05.82 Bulletin 82/19**

(45) Publication of the grant of the patent:
**19.02.86 Bulletin 86/08**

(84) Designated Contracting States:
**DE FR GB NL**

(56) References cited:
**DE-A-2 019 655**

**IBM TECHNICAL DISCLOSURE BULLETIN, vol.
22, no. 12, May 1980, New York, P. HO et al.
"Self-aligned process for forming metal-silicide
and polysilicon composite base contact", pages
5336-5338**

**JOURNAL OF VACUUM SCIENCE AND
TECHNOLOGY, vol. 17, no. 4, July/August
1980, New York, P. MURARKA "Refractory
silicides for integrated circuits"**

(73) Proprietor: **FUJITSU LIMITED**
**1015, Kamikodanaka Nakahara-ku
Kawasaki-shi Kanagawa 211 (JP)**

(72) Inventor: **Inoue, Shin-ichi**
**2797, Arima Takatsu-ku
Kawasaki-shi Kanagawa 213 (JP)**
Inventor: **Toyokura, Nobuo**
**1569-1, Shinsaku Takatsu-ku
Kawasaki-shi Kanagawa 213 (JP)**
Inventor: **Ishikawa, Hajime**
**18-22, Sumiregaoka Kohoku-ku
Yokohama-shi Kanagawa 223 (JP)**

(74) Representative: **Fane, Christopher Robin King
et al
HASELTINE LAKE & CO. Hazlitt House 28
Southampton Buildings Chancery Lane
London, WC2A 1AT (GB)**

## Description

### Background of the invention
### Field of the invention

The present invention relates to semiconductor devices, and more particularly to semiconductor devices having a conductor layer being made of a relatively low resistance metal silicide for electrodes and interconnections.

### Description of the prior art

In a semiconductor device such as an IC or a LSI, active elements and passive elements which are formed in a semiconductor substrate are electrically connected to each other by interconnection electrodes (conductor layers) to form a desired circuit. Metal such as aluminum (Al), molybdenum (Mo), tungsten (W), tantalum (Ta), titanium (Ti) and nickel (Ni) are used as the material for the interconnection electrodes. These metals have good adhesion to an insulating film of silicon dioxide formed on the semiconductor substrate and good workability (i.e. the metals are relatively easily etched by a suitable etchant). However, aluminum can not withstand the high temperature in heat-treatments involved in the production of a semiconductor device. Refractory metals such as molybdenum and tungsten can withstand the high temperature in the heat-treatments but can not withstand the high-temperature oxidizing ambient.

Polycrystalline silicon is used widely for the above interconnection electrodes and gate electrodes. The polycrystalline silicon contains impurities of phosphorus (P), arsenic (As), antimony (Sb), boron (B), gallium (Ga) or indium (In) so as to improve (i.e. reduce) its electric conductivity. The interconnection electrode of the polycrystalline silicon containing the impurities can be used as an impurity diffusion source when prescribed acceptor or donor impurities are introduced into the semiconductor substrate by diffusion. Furthermore the interconnection electrode of the polycrystalline silicon can be thermally oxidized to form an oxide layer (i.e. insulating layer), then another interconnection electrode is formed on the oxide layer to make a multilayer. However, the polycrystalline silicon has a relatively high specific resistance and the resistance of the interconnection electrode is increased by decreasing its cross-sectional area due to the thermal oxidation, so that a switching time of a semiconductor element is increased. Since the oxidation rate of the polycrystalline silicon is relatively low, a long thermal oxidation treatment time is necessary for forming a thick oxide layer which has a high dielectric strength. The long thermal oxidation treatment causes an undesired enlargement of the diffused (i.e. impurity introduced) region.

Metal silicides can be used as material of the above-mentioned interconnection electrodes (for example, cf. S. P. Murarka, "Refractory silicides for integrated circuits", J. Vac. Sci. Technol., 17(4), Jul./Aug. 1980, pp. 775—792). Since the metal silicides have a lower specific resistance than that of the polycrystalline silicon and withstand the high temperature and the high temperature oxidizing ambient in the production process of an integrated circuit, they are suitable as the material of the interconnection electrode. However, the metal silicide has the following disadvantages: (1) when a source electrode and a drain electrode made of the metal silicide are heated at a high temperature above 800°C during a heat-treatment (e.g. annealing for diffusion), the ohmic contact between the source and drain electrodes and the $n^+$ type source and drain regions of the substrate silicon is deteriorated; (2) when a gate electrode made of the metal silicide is used, the instability of the properties of an MOS transistor is caused by movable ions such as $Na^+$; and (3) in order to obtain an oxide layer having a sufficient thickness by oxidizing the metal silicide, it is necessary to carry out the oxidation treatment at a high temperature for a long time.

In IBM technical Disclosure Bulletin, Vol. 22, No. 42, May 1980, pages 5336—5338, there is described a semiconductor device in which the surface of a metal silicide conductor layer, e.g. of $WSi_2$, on a p+ polycrystalline silicon underlayer on a silicon substrate is oxidised to form an oxide of the metal silicide. The metal silicide is thus electrically connected to an impurity introduced region of the substrate.

### Summary of the invention

The present inventors have found that when a metal silicide is doped with prescribed impurities (i.e. acceptor and donor impurities), the oxidation rate of the doped metal silicide is faster than that of the non-doped metal silicide and its specific resistance is an order of magnitude lower as compared with a conventionally used polycrystalline silicon.

An object of the invention is to make it easier to form a suitable insulating oxide layer on interconnection electrodes.

A further object of the present invention is to provide a semiconductor device of which the switching time is shorter than that of a conventional semiconductor device provided with interconnection electrodes of polycrystalline silicon.

A semiconductor device according to the present invention comprises a semiconductor substrate provided with an impurity introduced region of a desired conductivity type, a conductor layer of a metal silicide which is electrically connected to a prescribed surface portion of the semiconductor substrate and/or is placed on an insulating film formed on the semiconductor substrate, and an insulating layer of an oxide of said metal silicide formed on the conductor layer, wherein the said metal silicide is doped with prescribed impurities in an amount effective to increase its rate of oxidation, and at least $1 \times 10^{20}$ atoms/cm$^3$, but not so great as to impair its adhesion to the substrate on heat treatment.

A compound of silicon and at least one metal selected from the group consisting of molybdenum (Mo), tungsten (W), tantalum (Ta) and titanium (Ti) can be used as the metal silicide. It is preferable to use a silicide of molybdenum.

Donor impurities such as phosphorus (P), arsenic (As) and antimony (Sb) or acceptor impurities such as boron (B) can be used as the impurities doped into (i.e. contained in) the metal silicide. Selection of the impurities to be used depends upon the conductivity type of the silicon semiconductor substrate and of the impurity introduced region such as base, emitter, source and drain regions.

It is preferable that the concentration of the impurities contained in the metal silicide ranges from $1 \times 10^{20}$ to $4 \times 10^{21}$ atoms/cm$^3$. In the case where the concentration of the impurities is less than $1 \times 10^{20}$ atoms/cm$^3$, a high acceleration effect of the oxidation rate of the metal silicide (to be explained hereinafter) can not be obtained. In the case where the concentration is more than $4 \times 10^{21}$ atoms/cm$^3$, the metal silicide layer containing the impurities may peel off from the surface of the semiconductor substrate during a heat-treatment and the contained impurities may pass through a gate insulating film and then diffuse into the substrate for a metal-insulator-semiconductor (MIS) type element during a heat-treatment. Therefore, in this case, it is difficult to obtain semiconductor devices having a high reliability and good operating properties.

It is preferable to form a polycrystalline semiconductor layer (e.g. a polysilicon layer) under the conductor layer of the metal silicide. The formation of the polycrystalline semiconductor layer brings about an advantage, for example, in case of the use of it for a gate electrode, conventional design factors for a silicon gate metal-oxide-semiconductor (MOS) device can be used without any changes, since the threshold voltage of the MOS depends on the work function of polycrystalline silicon.

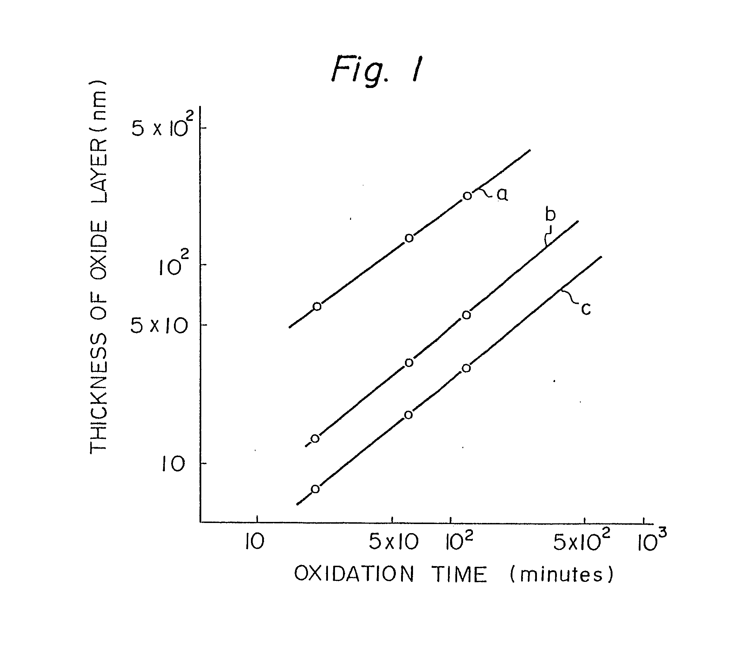

In the case where a conductor layer of a metal silicide is thermally oxidized to form an insulating oxide layer on the conductor layer, the oxidation rate of the metal silicide which is doped with impurities in accordance with the present invention is faster than that of a non-doped metal silicide and than that of a single crystalline silicon. Namely, the thick insulating oxide layer can be more easily formed on the doped metal silicide as compared with on the non-doped metal silicide and the single crystalline silicon, as is evident from Fig. 1.

Data of Fig. 1 are obtained from the following experiment.

A single crystalline silicon (Si) substrate and targets consisting of pieces of silicon and a plate of molybdenum which is covered by the silicon pieces are placed in a sputtering apparatus (DC magnetron sputtering type). Feeding inert gas (e.g. argon gas) into the apparatus, a sputtering treatment is performed to deposit a molybdenum silicide layer on the silicon substrate under such conditions as the output power of the apparatus of 200 W, the gas pressure of $7.98 \cdot 10^{-3}$ mbar

($6.0 \times 10^{-3}$ Torr). In the case where a gas comprising phosphorus (e.g. phosphine gas: PH$_3$) is added to the inert gas (argon gas), it is possible to deposit a molybdenum silicide layer doped with phosphorus, according to the present invention, on the silicon substrate. For example, the gas pressure of phosphine gas is $1.46 \cdot 10^{-3}$ mbar ($1.1 \times 10^{-3}$ Torr) and the gas pressure of argon gas is $6.51 \cdot 10^{-3}$ mbar ($4.9 \times 10^{-3}$ Torr). The concentration of phosphorus in the molybdenum silicide layer can be controlled by regulating the feed rate and the feed period of phosphine gas. The molybdenum silicide layer doped with phosphorus, the non-doped molybdenum silicide layer and a single crystalline silicon substrate oriented in the (100) plane are oxidized in an oxygen atmosphere containing steam at 750°C to form oxide layers, respectively. The relationship between the thickness of the formed oxide layers and the oxidation time is shown in Fig. 1. In Fig. 1, the lines a, b and c indicate the molybdenum silicide layer doped with phosphorus (phosphorus concentration: $1 \times 10^{21}$ atoms/cm$^3$), the non-doped molybdenum silicide layer and the silicon substrate, respectively.

Brief explanation of the drawings

Fig. 1 is a graph showing the relationship between the thickness of the formed oxide layer and the oxidation time;

Fig. 2 is a sectional view of a metal insulator semiconductor type field effect transistor according to the present invention,

Fig. 3 is a sectional view of a bipolar transistor according to the present invention,

Fig. 4 is a sectional view of another bipolar transistor according to the present invention,

Fig. 5 is a sectional view of a single-transistor single-capacitor memory cell according to the present invention,

Fig. 6 is a sectional view of another single-transistor single-capacitor memory cell according to the present invention,

Fig. 7 is a sectional view of another single-transistor single-capacitor memory cell according to the present invention,

Fig. 8 is a sectional view of a PN junction diode according to the present invention,

Fig. 9 is a sectional view of a bipolar transistor according to the present invention,

Fig. 10 is a sectional view of metal insulator semiconductor field effect transistors forming an inverter circuit according to the present invention,

Fig. 11 is a sectional view of a single-transistor single-capacitor memory cell according to the present invention, and

Fig. 12 is a sectional view of a semiconductor non-volatile memory cell for EPROM.

Detailed description of the preferred embodiments

Embodiment 1

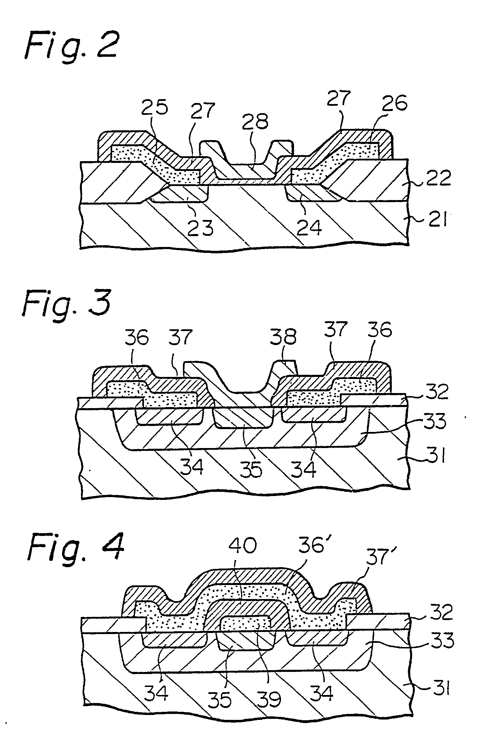

A semiconductor device i.e. a metal-insulator-semiconductor type field effect transistor (MIS-FET) (Fig. 2), as an embodiment of the present invention, has a metal silicide doped with impurities serving as a source electrode, a drain electrode and impurity diffusion sources. In Fig. 2, the MIS-FET comprises a P type silicon substrate 21, a field insulating film 22, an N⁺ type source region 23, an N⁺ type drain region 24, the source electrode 25, the drain electrode 26, an insulating oxide layer 27 and a gate electrode 28.

The above MIS-FET is produced according to the following procedures. The silicon substrate 21 is selectively oxidized by a conventional selective oxidation process to form the filed insulating (silicon dioxide: $SiO_2$) film 22. A molybdenum silicide layer doped with phosphorus ($1 \times 10^{21}$ atoms/cm³) and having a thickness of approximately 400 nm is deposited on the field insulating film 22 and the uncovered surface of the silicon substrate 21 by a conventional sputtering method and then is selectively etched by a conventional photoetching process to form the source and drain electrodes 25 and 26. Then the source and drain electrodes 25 and 26 and the exposed surface of the silicon substrate 21 are oxidized by heating them in a steam atmosphere at a temperature of 750°C for a period of 100 minutes to form the insulating oxide layer 27 on them. The portions of the oxide layer 27 on the electrodes 25 and 26 have a thickness of approximately 200 nm and the portion on the exposed surface of the silicon substrate 21 has a thickness of from 25 to 30 nm. The silicon substrate 21 provided with the insulating oxide layer 27 is heated in a dry oxygen atmosphere at a temperature of 900°C for a period of 20 minutes to diffuse the phosphorus impurities contained in the electrodes 25 and 26 into the silicon substrate 21. As a result, the source region 23 and the drain region 24 having a depth of 300 nm and a surface concentration of $1 \times 10^{21}$ atoms/cm³ are formed. At this time, the insulating oxide layer 27 is densified. Then an electrically conductive material (e.g. polycrystalline silicon, aluminum) is deposited on the insulating oxide layer 27 and the field oxide film 22 by, for example, a conventional vapor growth deposition method or vacuum evaporation method to form a conductor layer. The conductor layer is selectively etched by a conventional photoetching process to form the gate electrode 28.

In the production of the MIS-FET, it is possible to determine the locations of the source and drain region by suitably forming the source and drain electrodes of a molybdenum silicide doped with phosphorus, and it is possible to define the planar dimensions of the source and drain region in a small size. Therefore, the MIS-FET can be produced in a smaller size, so that the density of MIS-FETs in an integrated circuit can be increased. Furthermore, the junction capacitance between the drain region and the silicon substrate can be reduced, is that the operating speed of the MIS-FET is satisfactory fast.

Since the thick insulating oxide layer is present between the gate electrode and the source and drain electrodes, the dielectric strength of the oxide layer is high and the parasilic capacitance is small.

Embodiment 2

Fig. 3 shows a bipolar transistor of another embodiment of the present invention. The bipolar transistor has the metal (molybdenum) silicide doped with impurities (borons) serving as a base electrode and an impurity diffusion source for a base contact region.

In Fig. 3, the bipolar transistor comprises an N type silicon substrate or epitaxial layer 31 being a collector region, a field insulating film 32, a P type base region 33, a P⁺ type base contacting region 34, an N⁺ type emitter region 35, a base electrode 36 of the molybdenum silicide doped with borons, an insulating oxide layer 37, an emitter electrode 38 and a collector electrode (not shown).

The above bipolar transistor is produced according to the following procedures. The silicon substrate 31 is thermally oxidized to form the field insulating (silicon dioxide) film 32. The field insulating film 32 is selectively etched by a photoetching process to form an opening. Through the opening acceptor impurities (i.g. gallium) are introduced (diffused) into the silicon substrate 31 in accordance with a conventional selective diffusion process to form the P type base region 33. Then a molybdenum silicide layer doped with boron and having a thickness of approximately 400 nm is deposited on the field insulating film 32 and on the uncovered surface of the silicon substrate 31 by a sputtering method, and then is selectively etched by a photoetching process to form the base electrode 36. Then the base electrode 36 and the exposing surface of the silicon substrate 31 are oxidized by heating them in a steam atmosphere at 750°C for 100 minutes to form the insulating oxide layer 37 of approximately 200 nm thickness on the base electrode 36 and an oxide film (not shown) of from 25 to 30 nm thickness on the exposed surface of the silicon substrate 31. The oxide film is removed by immersing the silicon substrate into an etching solution of hydrofluoric acid for a short time, simultaneously the thickness of the insulating oxide layer 37 is reduced to approximately 160 nm. Donor impurities of phosphorus or arsenic are introduced into the exposed portion of the base region 33 by a conventional diffusion method to form the N⁺ type emitter region 35. Since the diffusion treatment involves a high temperature, during the treatment the boron impurities contained in the base electrode 36 are diffused into the base region 33 to form the P⁺ type base contacting region 34 which improves the electrical connection between the base electrode 36 and the base region 33. Then the emitter electrode 38 of aluminum is formed on the emitter region 35 by a conventional process comprising a vacuum evaporation step and a photo-etching step.

Embodiment 3

Fig. 4 shows another bipolar transistor having a different structure from the bipolar transistor of Embodiment 2 and is the other embodiment of the present invention.

As shown in Fig. 4, the bipolar transistor comprises an emitter electrode 39 made of a molybdenum silicide doped with phosphorus (or arsenic) and serving as an impurity diffusion source for the emitter region 35, an insulating oxide layer 40 formed on the emitter electrode 39 and a base electrode 36' a portion of which electrode 36' lies on the insulating oxide layer 40. The N type silicon substrate 31, the field insulating film 32, the P type base region 33, the $P^+$ type base contacting region 34 and the $N^+$ type emitter region 35 are the same in the bipolar transistors of Embodiment 3 (Fig. 4) and Embodiment 2 (Fig. 3).

The bipolar transistor of Embodiment 3 is produced according to the following procedures. After the formation of the base region 33, the molybdenum silicide layer doped with phosphorus having a thickness of approximately 400 nm is deposited on the field insulating layer 32 and the uncovered base region 33 by a sputtering method, and then is selectively etched by a photoetching process to form the base electrode 39. Then the base electrode 39 and the exposed surface of the base region 33 are oxidized by heating them in the same conditions as those in Embodiment 2. As a result, the insulating oxide layer 40 having a thickness of approximately 200 nm is formed and an oxide film (not shown) having a thickness of from 25 to 30 nm is formed on the base region 33. After the removal of the oxide film by etching, a molybdenum silicide layer doped with boron and having a thickness of approximately 400 nm is deposited on the insulating oxide layer 40, the field insulating film 32 and the exposed surface of the base region 33 by a sputtering method and then is selectively etched to form the base electrode 36'. The obtained silicon substrate 31 is heated in dry oxygen at 1000°C for 20 minutes, so that an insulating oxide layer 37' is formed by the oxidation of the base electrode 36' and the impurities contained in the emitter and base electrodes 40 and 36' are diffused into the base region 33 to form the emitter region 35 and the base contact region 34, respectively, as shown in Fig. 4.

In the case of the bipolar transistors of Embodiments 2 and 3, since the base contacting region and/or the emitter region can be formed by diffusing the impurities contained in the electrodes of the molybdenum silicide into the base region, it is possible to make the space between the base and emitter electrodes small and to obtain a sufficiently fast switching speed of the bipolar transistor. Furthermore, the electrode of the molybdenum silicide doped with effective impurities has a relatively low resistance, so that the electrode can be used as a interconnector between bipolar transistors, resistors and transistors in an integrated circuit.

Embodiment 4

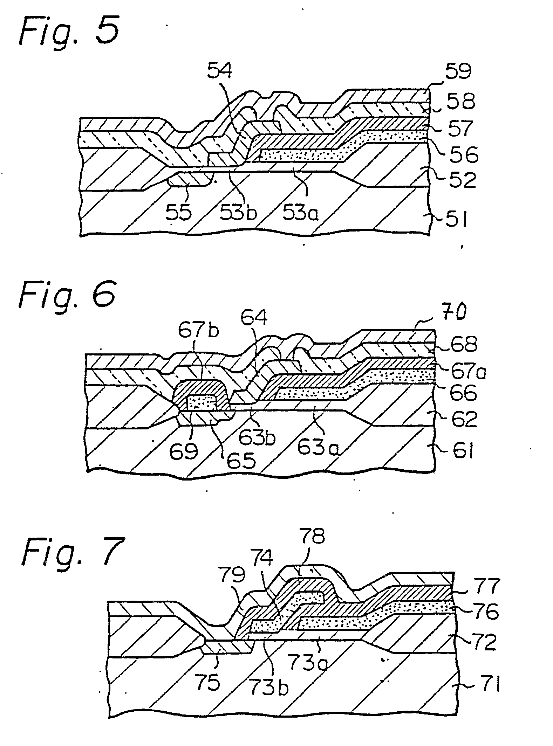

Fig. 5 shows a single-transistor single-capacitor memory cell for a dynamic random access memory (RAM) device as a semiconductor device according to an embodiment of the present invention.

In Fig. 5, the single-transistor single-capacitor memory cell comprises a P type silicon substrate 51, a field insulating film 52, gate insulating films 53a and 53b, a transfer gate electrode 54, an $N^+$ type drain region 55, an electrode 56 for a capacitor, an insulating oxide layer 57, a phosphosilicate glass (PSG) layer 58 and a word line 59.

The above memory cell is produced according to the following procedures. First, the silicon substrate 51 is selectively oxidized to form the field insulating (silicon dioxide) film 52. Then the gate insulating film 53a is formed on the surface of the silicon substrate which is defined by the field insulating film 52. A molybdenum silicide layer doped with phosphorus and having a thickness of approximately 400 nm is deposited on the field insulating film 52 and on the gate insulating film 53a by a sputtering process, and then it is selectively etched to form the electrode 56. A portion of the gate insulating film 53a which is not covered with the electrode 56 is removed by etching to expose a portion of the silicon substrate 51. Then the electrode 56 and the exposed portion of the silicon substrate 51 are oxidized by heating them in a steam atmosphere at 750°C for 100 minutes to form the insulating oxide layer 57 of approximately 200 nm thickness on the electrode 56 and an oxide film of from 25 to 30 nm thickness on the silicon substrate 51. Then the heat treatment is carried out in a dry oxygen atmosphere at 900°C to increase the thickness of the oxide film to approximately 35 nm, thus the insulating oxide film 53b for a transfer gate is obtained on the silicon substrate 51. At this time, the insulating oxide layer 57 is densified. Then the transfer gate electrode 54 of polycrystalline silicon lying on the oxide film 53b and on the insulating oxide layer 57, as shown in Fig. 5, is formed by a vapor growth deposition process of polycrystalline silicon and a photoetching process. Donor impurities (e.g. phosphorus or arsenic) are introduced into the silicon substrate 51 by a conventional ion implantation method in which the transfer gate electrode 54 and the field insulating film 52 serve as masks, so that the $N^+$ type drain region 55 and a bit line (extending in the direction vertical to the paper surface in Fig. 5) are formed. The phosphosilicate glass layer 58 having a thickness of approximately 800 nm is coated on the entire surface and a portion of the layer 58 on the transfer gate electrode 54 is removed by a photoetching process. Then a conductor layer of aluminum is deposited on the entire surface and selectively etched by a photoetching process to form the word line 59.

Embodiment 5

Fig. 6 shows a single-transistor single-capacitor memory cell of another embodiment of the present invention which has a similar structure to that of the memory cell shown in Fig. 5.

In Fig. 6, the single-transistor single-capacitor memory cell comprises a P type silicon substrate 61, a field insulating film 62, gate insulating films 63a and 63b, a transfer gate electrode 64, an $N^+$ type drain region 65, an electrode 66 for a capacitor, insulating oxide layer 67a and 67b, a phosphosilicate glass layer 68, a bit line 69 and a word line 70.

The above memory cell is produced according to the following procedures. At first, the silicon substrate 61 is selectively oxidized to form the field insulating (silicon dioxide) film 62). Then the gate insulating film 63a is formed on the surface of the silicon substrate which is defined by the insulating film 62. A molybdenum silicide layer doped with phosphorus and having a thickness of approximately 400 nm is deposited on the field and gate insulating films 62 and 63a by a sputtering process and then is selectively etched to form the electrode 66 for a capacitor. A portion of the gate insulating film 63a which is not covered with the electrode 66 is removed by etching to expose a portion of the silicon substrate 61. Then, a molybdenum silicide doped with phosphorus and having a thickness of approximately 400 nm is selectively formed on a portion of the exposed surface of the silicon substrate 61 to form the bit line 69. The obtained silicon substrate 61 is heat-treated in a steam atmosphere at 750°C for 100 minutes to form the insulating oxide layers 67a and 67b having a thickness of approximately 200 nm on the electrode 66 and on the bit line 69, respectively. At this time, the remaining exposed surface of the silicon substrate 61 is simultaneously oxidized to form an oxide film having a thickness of from 25 to 30 nm. Then, the silicon substrate 61 is heat-treated in a dry oxygen atmosphere at 900°C to increase the thickness of the oxide film to 35 nm, thus the insulating oxide film 63b for the transfer gate is obtained. Simultaneously, by this heat-treatment the insulating oxide layers 67a and 67b are densified and the phosphorus impurities contained in the bit line 69 are diffused into the silicon substrate 61 to form the $N^+$ type drain region 65. The transfer gate 64 of polycrystalline silicon laying on the oxide film 63b and on the insulating oxide layer 67a is formed by a vapor deposition process of polycrystalline silicon and a photo-etching process. Donor impurities (e.g. phosphorus or arsenic) are ion-implanted into the silicon substrate 61 by using the transfer gate electrode 64, the field insulating film 62 and the bit line 69 as masks and the heat-treatment is carried out at 900°C for 20 minutes, so that an additional portion of the $N^+$ type drain region 65 is formed. The phosphosilicate glass layer 68 having a thickness of approximately 800 nm is coated on the entire surface and portion of the layer 68 is removed by a photoetching process. Then a conductor layer of aluminum is deposited on the entire surface and selectively etched by a photo-etching process to form the word line 70.

Embodiment 6

Fig. 7 shows a single-transistor single-capacitor memory cell of a dynamic RAM device according to still another embodiment of the present invention.

In Fig. 7, the single-transistor single-capacitor memory cell comprises a P type silicon substrate 71, a field insulating film 72, gate insulating films 73a and 73b, a transfer gate electrode 74, an $N^+$ type drain region 75, an electrode 76 for a capacitor, insulating oxide layers 77 and 78 and a bit line 79.

The above memory cell is produced according to the following procedures. First, the silicon substrate 71 is selectively oxidized to form the field insulating film 72 on the silicon substrate 71. Then the gate insulating film 73a is formed on the uncovered surface of the silicon substrate 71. A molybdenum silicide layer doped with phosphorus and having a thickness of approximately 400 nm on its entire surface, i.e. on the field and gate insulating films 72 and 73a by a sputtering process and then is selectively etched to form the electrode 76 for a capacitor. A portion of the gate insulating film 73a which is not covered with the electrode 76 is removed by etching to expose a portion of the silicon substrate 71. Then a first heat-treatment (e.g. a thermal oxidation treatment is carried out in a steam atmosphere at 750°C for 100 minutes to form the insulating oxide layer 77 having a thickness of approximately 200 nm on the electrode 76 and simultaneously to form an oxide film having a thickness of from 25 to 30 nm on the exposed portion of the silicon substrate 71. Subsequently a second heat-treatment is carried out in a dry oxygen atmosphere at 900°C for 180 minutes to increase the thickness of the oxide film to 35 nm, thus the gate insulating film 73b having a thickness of 35 nm is obtained on the silicon substrate 71. At this time, due to the heat-treatment the insulating oxide layer 77 is densified. A molybdenum silicide layer doped with phosphorus and having a thickness of approximately 400 nm is formed on the entire surface (i.e. on the field and gate insulating films 72 and 73b and on the insulating oxide layer 76) by the sputtering process and then is selectively etched to form the transfer gate electrode 74. Then donor impurities (phosphorus or arsenic) are ion-implanted into the silicon substrate 71 by using the transfer gate electrode 74 and the field insulating film 72 as masks to form the $N^+$ type drain region 75. A third heat-treatment is carried out in a steam atmosphere at 750°C for 100 minutes to form the insulating oxide. layer 78 having a thickness of approximately 200 nm on the transfer gate electrode 74. Subsequently a fourth heat-treatment is carried out in a dry oxygen atmosphere at 900°C for 180 minutes to densify the insulating oxide layer 78. An oxide film (not shown) which is formed on the drain region 75 of the silicon substrate 71 by the third and fourth heat-treatments is removed by immersing the silicon substrate 71 into an etching solution of hydrofluoric acid for a short time. In this case, since the oxide film on the drain region 75 is much thinner than the insulating oxide layers 76 and 78, no mask is necessary for a selective etching. Then a conductor layer of aluminum is deposited on the entire surface and selectively etched by a photoetching process to form the bit line 79.

In the single-transistor single-capacitor memory cell of the above-mentioned embodiments 4, 5 and 6, since the insulating oxide layers 57, 67a and 77 formed between the electrodes 56, 66 and 76 for a capacitor and the transfer gate electrodes 54, 64 and 74 have a sufficient thickness and a sufficient denseness, the dielectric strength of the layers is sufficiently high. Therefore, a semiconductor memory device having a high reliability can be provided according to the above-mentioned embodiments of the present invention.

In the above-mentioned production processes of the memory cells of embodiments 4, 5 and 6, the gate insulating films 53b, 63b and 73b under the transfer gate electrodes 54, 64 and 74 are simultaneously formed at the formation of the insulating oxide layers 57, 67a and 76. However, it is possible to form another oxide film having a desired thickness after the removal of the gate insulating films.

Embodiment 7

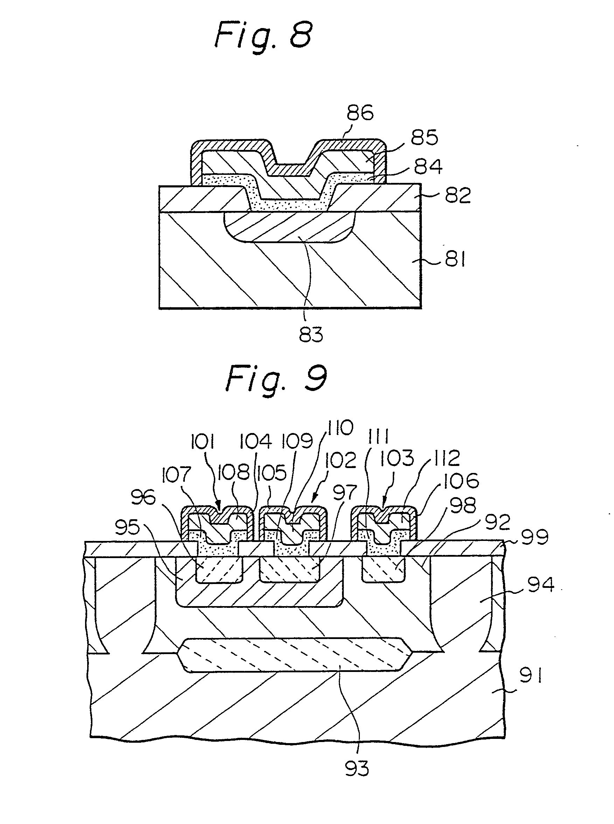

Fig. 8 shows a PN junction diode as a semiconductor device according to an embodiment of the present invention. The PN junction diode has a metal silicide layer and a semiconductor layer under it.

In Fig. 8, the PN junction diode comprises a P type silicon substrate 81, a field insulating film 82, an $N^+$ type region 83, a polycrystalline silicon layer 84, an electrode 85 of molybdenum silicide doped with phosphorus and an insulating oxide layer 86.

The above PN junction diode is produced according to the following procedures. At first, the silicon substrate 81 is thermally oxidized to form the field insulating film 82 of silicon dioxide. The film 82 is selectively etched by a photo-etching process to form an opening in which a portion of the silicon substrate 81 is exposed. Then the semiconductor layer 84 of polycrystalline silicon (or amorphous silicon) is deposited on the exposed portion of the substrate 81 and on the field insulating film 82 by a sputtering process (or a process of thermal) decomposition of silicon hydride compound such as monosilane: $SiH_4$). It is preferable that the thickness of the semiconductor layer under the metal silicide doped with effective impurities is in the range of from 50 to 300 nm. If the thickness of the semiconductor layer is less than 50 nm, cracks in it and in the metal silicide layer occur during a high-temperature heat-treatment (e.g. annealing for diffusion). It is preferable to make the maximum thickness of the semiconductor layer 300 nm with due consideration of the total thickness of an electrode, an etching treatment and coverage of another conductor layer on it. In this case, the formed semiconductor layer 84 has a thickness of approximately 50 nm. Then the molybdenum silicide layer 85 having a thickness of approximately 300 nm is deposited on the polycrystalline silicon layer 84 by a sputtering process. The silicon substrate 81 is heat-treated in an oxygen atmosphere at 1000°C for 20 minutes to diffuse the phosphorus impurities contained in the molybdenum silicide into the silicon substrate 81 through the polycrystalline layer 84. Thus, the diffused impurities form the $N^+$ type region 83. Simultaneously the molybdenum silicide layer 85 is thermally oxidized to form the insulating oxide layer 86 having a thickness of 200 nm.

Since the depth of the $N^+$ type region 83, i.e. the diffusion depth of the impurities can be made uniform in the PN junction diode having the above-mentioned structure, in the case of the production of a large number of PN junction diodes, the dispersion of values of breakdown voltage of the junction diodes is small.

Embodiment 8

Fig. 9 shows a bipolar transistor as a semiconductor device according to an embodiment of the present invention. In this embodiment, an emitter electrode, a base electrode and a collector electrode of the bipolar transistor comprise a metal silicide layer and a semiconductor layer under it and these electrodes are covered with insulating oxide layers, respectively.

In Fig. 9, the bipolar transistor comprises a P type substrate 91, an N type silicon epitaxial layer 92 serving as a collector region, an $N^+$ type buried layer 93, a P type isolation region 94, a P type base region 95, a $P^+$ type base contact region 96, an $N^+$ type emitter region 97, an $N^+$ type collector contact region 98, an insulating film 99, a base electrode 101, an emitter electrode 102, a collector electrode 103 and insulating oxide layers 104, 105 and 106. The base electrode 101 consists of a polycrystalline silicon layer 107 and a molybdenum silicide layer 108 doped with acceptor impurities (boron), the emitter electrode 102 consists of a polycrystalline silicon layer 109 and a molybdenum silicide layer 110 doped with donor impurities (such as phosphorus and arsenic) and the collector electrode 103 consists of a polycrystalline silicon layer 111 and a molybdenum silicide layer 112 doped with donor impurities (such as phosphorus and arsenic).

The above bipolar transistor is produced according to the following procedures.

According to known techniques, donor impurities of antimony are selectively introduced into the silicon substrate 91 to form an $N^+$ type region 93 for a buried layer. Then the N type silicon epitaxial layer 92 is formed on the silicon substrate 91 by an epitaxial growth process. At this time, the buried layer 93 is formed between the silicon epitaxial layer 92 and the silicon substrate 91. Acceptor impurities are selectively introduced into the silicon epitaxial layer 92 so as to arrive at the silicon substrate 91, thus the P type isolation region 94 is formed. Then acceptor impurities are selectively introduced into the epitaxial layer 92 which is defined by the isolation region 94 to form the base region 95. The insulating film 99 is formed on the epitaxial layer 92 including the base region 95 and the isolation region 94, for example, by thermally oxidizing the epitaxial layer 92, and then is selectively removed by a photoetching process to form openings.

The above production steps are well known in a conventional process for producing a bipolar transistor in a bipolar integrated circuit device.

In accordance with the present invention, after the formation of the opening for a base electrode, the following production steps are performed: A polycrystalline silicon layer 107 having a thickness of approximately 50 nm is formed on the insulating film 99 and on the exposed portion of the silicon substrate 91 within the opening by a sputtering process. In this case, an amorphous silicon layer may be formed instead of the polycrystalline silicon layer. A molybdenum silicide layer 108 doped with boron impurities and having a thickness of approximately 300 nm is deposited on the polycrystalline silicon layer 107 by a sputtering process. Then the molybdenum silicide layer 108 and the polycrystalline silicon layer 107 are selectively etched by a photoetching process to form the base electrode 101 having a predetermined pattern. The obtained silicon substrate is heat-treated in an oxygen atmosphere at 900°C for 20 minutes to diffuse the boron impurities contained in the molybdenum silicide layer 108 into the base region 95 through the polycrystalline silicon layer 107, so that the P⁺ type base contact region 96 is formed. At this time, the molybdenum silicide layer 108 and the exposed side surface of the polycrystalline silicon layer 107 are thermally oxidized to form the insulating oxide layer 104.

The insulating film 99 is selectively etched to form an opening for an emitter electrode on the base region 95 and to form another opening for a collector electrode on the collector region 92 of the epitaxial layer. Then a polycrystalline silicon layer having a thickness of approximately 50 nm is deposited on the entire surface including the exposed surfaces of the base and collector regions within the openings by a sputtering process. Subsequently, a molybdenum silicide layer doped with donor impurities of phosphorus (or arsenic) and having a thickness of approximately 300 nm is deposited on the polycrystalline silicon layer. The molybdenum silicide layer and the polycrystalline silicon layer are selectively etched to form the emitter electrode 102 consisting of the molybdenum silicide layer 110 and the polycrystalline silicon layer 109 and the collector electrode 103 consisting of the molybdenum silicide layer 112 and the polycrystalline silicon layer 111. Then the obtained silicon substrate is heat-treated in an oxygen atmosphere at 900°C for 20 minutes, whereby the donor impurities contained in the molybdenum silicide layers 110 and 112 are diffused into the base region 95 and the collector region 92 through the polycrystalline silicon layers 109 and 111 to form the N⁺ type base contact region 97 and the N⁺ type collector contact region 98, respectively. At this time, the molybdenum silicide layers 110 and 112 and the exposed side surfaces of the polycrystalline silicon layers 101 and 111 are oxidized to form the insulating oxide layers 105 and 106, respectively.

In the above-mentioned bipolar transistor, the diffusion depth of the donor impurities (the depth of the emitter region) can be defined at a relatively shallow and uniform level, so that the bipolar transistor has a relatively high switching speed.

Incidentally, the above-mentioned electrodes 101, 102 and 103 are extended and are used as interconnection conductors to be connected to other elements in an integrated circuit.

Embodiment 9

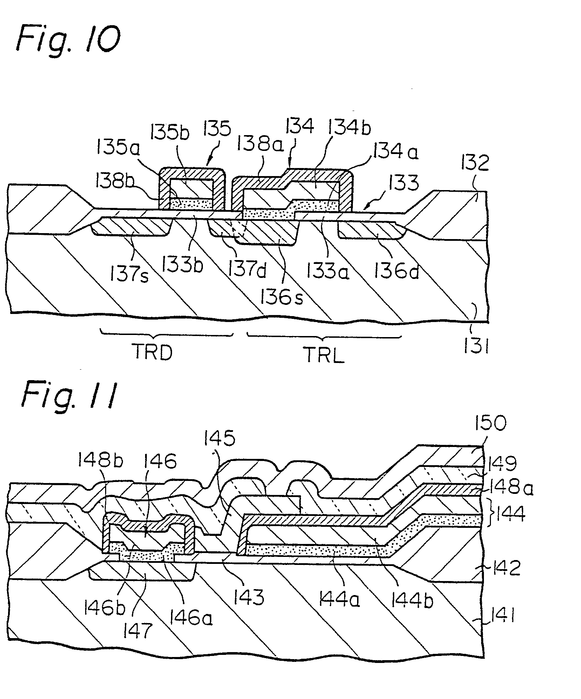

Fig. 10 shows two metal insulation semiconductor field effect transistors (MIS-FETs) forming an inverter circuit as a semiconductor device according to an embodiment of the present invention. In this embodiment, a gate electrode of a driven transistor (TRD) and an electrode for both gate and source of a load transistor (TRL) comprise a metal silicide layer doped with effective impurities and a semiconductor layer under it and these electrodes are covered with insulating oxide layers, respectively.

In Fig. 9, the driver transistor (TRD) and the load transistor (TRL) are formed in a P type silicon substrate 131 with a field insulating film 132. The TRD comprises a gate insulating film 133b, an N⁺ type source region 137s, a source electrode (not shown), an N⁺ type drain region 137d, an insulating oxide layer 138b and a gate electrode 135 comprising a polycrystalline silicon layer 135a and a molybdenum silicide layer 135b doped with phosphorus impurities. The TRL comprises a gate insulating film 133a, an N⁺ type source region 136s, an N⁺ type drain region 136d, a drain electrode (not shown), an insulating oxide layer 138a and a source and gate electrode 134 consisting of a polycrystalline silicon layer 134a and a molybdenum silicide layer 134b doped with phosphorus impurities.

The above MIS-FETs forming the inverter circuit are produced according to the following procedures. At first, the silicon substrate 131 is selectively oxidized to form the field insulating (SiO₂) film 132 by a conventional selective oxidation process. A gate insulating film 133, including the gate insulating films 133a and 133b, having a thickness of approximately 40 nm is formed on the portion of the silicon substrate 131 uncovered with the field insulating film 132. The gate insulating film 133 is selectively etched to form an opening in which a portion of the silicon substrate 131 is exposed. Then a polycrystalline silicon (or amorphous silicon) layer having a thickness of approximately 50 nm is deposited on the field and gate insulating films 132 and 133 and on the exposed portion of the silicon substrate 131 by sputtering. Subsequently a molybdenum silicide layer doped with phosphorus impurities and having a thickness of approximately 300 nm is deposited on the polycrystalline silicon layer by a sputtering process. Then the molybdenum silicide layer and the polycrystalline silicon layer are selectively etched by a photoetching process to form the gate electrode 135 consisting of the polycrystalline silicon layer 135a and the silicide layer 135b and to form the source and gate electrode 134 consisting of the polycrystalline silicon layer 134a and the silicide layer 134b. Arsenic impurities (As$^+$) are ion-implanted into the silicon substrate 131 by using the electrodes 134 and 135 and the field insulating film 132 as marks to form the N$^+$ type regions 137s, 137d, 136s and 136d. Then the obtained silicon substrate is heat-treated in an oxygen atmosphere at 1000°C for 20 minutes, whereby the phosphorus impurities contained in the molybdenum silicide layer 135b and 134b are diffused into the polycrystalline silicon layers 135a and 134a and further into the silicon substrate 131 through the polycrystalline silicon layer 134a to form the N$^+$ type source region 136s. At this time, the molybdenum silicide layers 135b and 134b and the exposed side surface of the polycrystalline silicon layers 135a and 134a are oxidized to form the insulating oxide layers 138a and 138b. Thereafter, portions of the gate insulating layers 133a and 133b are selectively etched to form openings (not shown) on the source region 137s and the drain region 136d, respectively. A conductor layer (of aluminum or metal silicide doped with effective impurities) is deposited on the entire surface and selectively etched to form the source electrode (not shown) of the TRD and the drain electrode (not shown) of the TRL.

Embodiment 10

Fig. 11 shows a single-transistor single-capacitor memory cell for a dynamic RAM device as a semiconductor device according to an embodiment of the present invention. The memory cell has a similar structure to that of the memory cell of Embodiment 5 except that an electrode for a capacitor and a bit line consist of a metal silicide layer and a semiconductor layer under it.

In Fig. 11, the single-transistor single-capacitor memory cell comprises a P type silicon substrate 141, a field insulating film 142, a gate insulating film 143, an electrode 144 for a capacitor, a transfer gate electrode 145, a bit line 146, an N$^+$ type drain region 147, insulating oxide layers 148a and 148b, a phosphosilicate glass layer 149 and a word line 150.

The above mentioned memory cell is produced according to the following procedures. At first, the silicon substrate 141 is selectively oxidized to form the field insulating film 142 by a conventional selective oxidation process. Then the gate insulating film 143 having a thickness of approximately 40 nm is formed on the surface of the silicon substrate 141 which is defined by the field insulating film 142. A portion of the gate insulating film 143 is removed by a photoetching process for form an opening which a portion of the silicon substrate 141 is exposed. In the exposed portion the drain region is to be formed afterwards. A polycrystalline silicon semiconductor layer including the polycrystalline silicon layers 144a and 146a and having a thickness of approximately 50 nm is deposited on the field and gate insulating films 142 and 143 and on the exposed portion of the silicon substrate 141, and then a molybdenum silicide layer including the layers 144b and 146b and having a thickness of 300 nm is deposited on the polycrystalline silicon layer. The molybdenum silicide is doped with phosphorus impurities during the formation thereof by a sputtering process. Then the molybdenum silicide layer and the polycrystalline silicon layer are selectively etched to form the electrode 144 to be used as a capacitor consisting of the polycrystalline silicon layer 144a and the silicide layer 144b and the bit line 146 consisting of the polycrystalline silicon layer 146a and the silicide layer 146b, respectively. The obtained silicon substrate is heat-treated in an oxygen atmosphere at 1000°C for 20 minutes, whereby the phosphorus impurities contained in the molybdenum silicide layer 146b are diffused into the silicon substrate 141 through the polycrystalline silicon layer 146a and the opening to form the drain region 147. At this time, the molybdenum silicide layers 144b and 146b and the exposed side surfaces of the polycrystalline silicon layers 144a and 146a are oxidized to form the insulating oxide layers 148a and 148b. Then, another molybdenum silicide layer doped with effective impurities (such as phosphorus, arsenic and boron) and having a thickness of approximately 40 nm is deposited on the insulating oxide layers 148a and 148b and on the field and gate insulating films 142 and 143 and then is selectively etched by a photoetching process to form the transfer gate electrode 145 lying on the gate insulating film 143 and the insulating oxide layer 148a. The phosphosilicate glass (PSG) layer 149 having a thickness of approximately 800 nm is coated on the entire surface i.e. on the transfer gate electrode 145, on the insulating oxide layers 148a and 148b and on the field insulating film 142 by a conventional chemical vapor deposition (CVD) process. Then a portion of the PSG layer 149 on the transfer gate electrode 145 is removed by a photo-etching process to expose a portion of the transfer gate electrode 145. A conductor layer of aluminum is deposited on the PSG layer 149 and on the exposed portion and then it is selectively etched to form the word line 150.

Embodiment 11

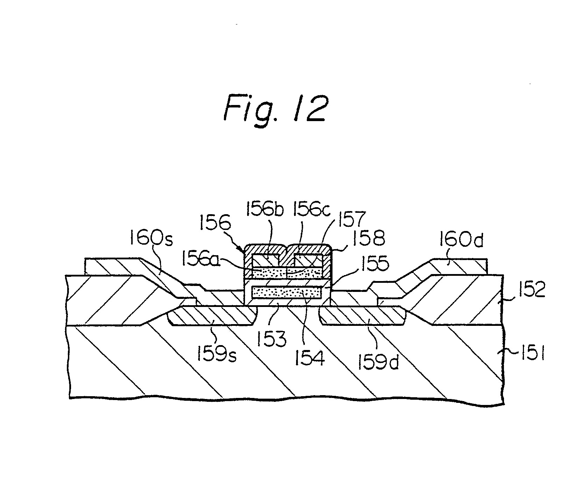

Fig. 12 show a semiconductor non-volatile memory cell for an EAROM (Electrically Alterable Read Only Memory) device as a semiconductor device according to an embodiment of the present invention.

In Fig. 12, the semiconductor non-volatile memory cell comprises a P type silicon substrate 151, a field insulating film 152, a gate insulating film 153, a floating gate electrode 154, an oxide film 155, a control gate electrode 156, a PN junction 157 formed in the control gate electrode 156, an insulating oxide layer 158, an N$^+$ type source region 159s, an N$^+$ type drain region 159d, a source electrode 160s and a drain electrode 160d. In this embodiment, the control gate electrode 156 comprises a polycrystalline silicon layer 156a, a molybdenum silicide layer 156b doped with donor impurities such as phosphorus and arsenic and a molybdenum silicide layer 156c doped with acceptor impurities such as boron, these silicide layers lying on the polycrystalline silicon layer 156a.

The above memory cell is produced according to the following procedures. First, the silicon substrate 151 is selectively oxidized to form the field insulating (SiO$_2$) film 152 by a conventional selective oxidation process. The gate insulating film 153 having a thickness of approximately 400 nm is formed on a portion of the silicon substrate 151, which portion is uncovered with the field insulating film 152. A polycrystalline silicon having a thickness of from 300 to 400 nm is deposited on the field and gate insulating films 152 and 153 and then is selectively etched to form the floating gate electrode 154 by a photoetching process. Donor impurities of phosphorus are ion-implanted into the silicon substrate 151 by using the field insulating film 152 and the floating gate electrode 154 as masks to form the N$^+$ type source and drain regions 159s and 159d, respectively. The obtained silicon substrate is heat-treated in an oxygen atmosphere at 1000°C for 20 minutes, whereby the source and drain regions 159s and 159d are annealed and simultaneously the floating gate electrode 154 is oxidized to form the oxide film 155 having a thickness of 30 nm. Then the polycrystalline silicon layer 156a having a thickness of 300 nm is formed to cover the oxide film 155, and the molybdenum silicide layer 156b doped with phosphorus impurities is formed on a part of the polycrystalline silicon layer 156a and the molybdenum silicide layer 156c doped with boron impurities is formed on another part of the polycrystalline silicon layer 156a. The silicide layers 156b and 156c have a thickness of approximately 300 nm, respectively. The formation of the polycrystalline silicon layer 156a and the silicide layer 156b and 156c can be carried out by a sputtering process and the patterning of these layers 156a, 156b and 156c can be carried out by a photoetching process. Then, the obtained silicon substrate is heat-treated in an oxygen atmosphere at 1000°C for approximately 10 minutes, whereby phosphorus impurities contained in the silicide layer 156b and boron impurities contained in the silicide layer 156c are diffused into the polycrystalline silicon layer 156a to form the PN junction 157. At this time, the molybdenum silicide layers 156b and 156c and the exposed surface of the polycrystalline silicon layer 156a are oxidized to form the insulating oxide layer 158. Portions of the gate insulating film 153 on the source and drain regions 159s and 159d are removed by a photoetching process to expose a portion of the source region 159s and a portion of the drain region 159d. Then a conductor layer of aluminum is deposited on the exposed portions, on the field insulating film 152 and on the insulating oxide layer 158 and then it is selectively etched to form the source electrode 160s and the drain electrode 160d.

In an embodiment of the present invention, since electrodes and interconnection electrodes of a semiconductor device are made of a metal silicide layer doped with effective impurities, a surface-protecting insulating layer or an insulating layer between conductor layers can be easily formed by oxidizing the electrodes. When a thermal oxidation treatment is carried out, the thickness of the insulating oxide layer formed on the metal silicide layer is much thicker than that of an oxide film formed on a silicon substrate. Therefore, when the oxide film is selectively removed by etching, it is unnecessary to use any mask. Furthermore, the thick insulating oxide layer can ensure a high dielectric strength and can decrease parasitic effects.

**Claims**

1. A semiconductor device comprising a semiconductor substrate provided with an impurity introduced region of a desired conductivity type, a conductor layer (25, 26, 56) of a metal silicide which is electrically connected to a prescribed surface portion of said semiconductor substrate and/or is placed on an insulating film formed on said semiconductor substrate, and an insulating layer (27, 57) of an oxide of said metal silicide formed on said conductor layer, wherein the said metal silicide contains prescribed impurities in an amount effective to increase its rate of oxidation, and at least $1 \times 10^{2o}$ atoms/cm$^3$, but not so great as to impair its adhesion to the substrate on heat treatment.

2. A semiconductor device claimed in claim 1, characterized in that said metal silicide is a compound of silicon and at least a metal selected from the group consisting of molybdenum, tungsten, tantalum and titanium.

3. A semiconductor device claimed in claim 2, characterized in that said metal is molybdenum, tungsten or tantalum.

4. A semiconductor device claimed in claim 1, characterized in that said semiconductor substrate is of single crystalline silicon and said impurities contained in the metal silicide are donor impurities such as phosphorus, arsenic or antimony or acceptor impurities such as boron.

5. A semiconductor device claimed in claim 4, characterized in that the concentration of said impurities in said metal silicide is in the range from $1 \times 10^{20}$ to $4 \times 10^{21}$ atoms/cm$^3$.

6. A semiconductor device claimed in claim 1, characterized in that a polycrystalline semiconductor layer is formed under said conductor layer.

7. A semiconductor device claimed in claim 6, characterized in that said polycrystalline semiconductor layer is of polycrystalline silicon.

8. A semiconductor device claimed in claim 7, characterized in that said polycrystalline silicon layer has a thickness in the range from 50 to 300 nm.

9. A semiconductor device claimed in claim 1, characterized in that another conductor layer is formed on said insulating layer.

## Patentansprüche

1. Halbleitervorrichtung mit einem Halbleitersubstrat, welches einen Bereich mit eingeführten Verunreinigungen von einem gewünschten Leitfähigkeitstyp umfaßt, einer Leiterschicht (25, 26, 56) aus Metallsilizid, welche elektrisch mit einem vorgeschriebenen Oberflächenabschnitt des genannten Halbleitersubstrats verbunden ist und/oder auf einem isolierenden Film angeordnet ist, der auf dem genannten Halbleitersubstrat gebildet ist, und mit einer isolierenden Schicht (27, 57) aus einem Oxid des genannten Metallsilizids, welche auf der genannten Leiterschicht gebildet ist, bei welcher das genannte Metallsilizid vorgeschriebene Verunreinigungen in einer Menge enthält, die die Erhöhung seiner Oxidationsrate bewirkt, und wenigstens $1 \times 20^{20}$ Atome/cm$^3$, jedoch nicht so groß ist, um seine Adhäsion an dem Substrat bei der Wärmebehandlung zu beeinträchtigen.

2. Halbleitervorrichtung nach Anspruch 1, dadurch gekennzeichnet, daß das genannte Metallsilizid eine Verbindung aus Silizium und wenigstens einem Metall ausgewählt aus der Gruppe bestehend aus Molybdän, Wolfram, Tantal und Titan ist.

3. Halbleitervorrichtung nach Anspruch 2, dadurch gekennzeichnet, daß das genannte Metall Molybdän, Wolfram oder Tantal ist.

4. Halbleitervorrichtung nach Anspruch 1, dadurch gekennzeichnet, daß das genannte Halbleitersubstrat ein einkristallines Silizium ist und die genannten Verunreinigungen, die in dem Metallsilizid enthalten sind, Donatorverunreinigungen wie Phosphor, Arsen oder Antimon oder Akzeptorverunreinigungen wie Bor sind.

5. Halbleitervorrichtung nach Anspruch 4, dadurch gekennzeichnet, daß die Konzentration der genannten Verunreinigungen in dem genannten Metallsilizid im Bereich von $1 \times 20^{20}$ bis $4 \times 10^{21}$ Atomen/cm$^3$ liegt.

6. Halbleitervorrichtung nach Anspruch 1, dadurch gekennzeichnet, daß eine polykristalline Halbleiterschicht unter der genannten Leiterschicht gebildet ist.

7. Halbleitervorrichtung nach Anspruch 6, dadurch gekennzeichnet, daß die genannte polykristalline Halbleiterschicht aus polykristallinem Silizium besteht.

8. Halbleitervorrichtung nach Anspruch 7, dadurch gekennzeichnet, daß die genannte polykristalline Siliziumschicht eine Dicke im Bereich von 50 bis 300 nm hat.

9. Halbleitervorrichtung nach Anspruch 1, dadurch gekennzeichnet, daß eine andere Leiterschicht auf der genannten isolierenden Schicht gebildet ist.

## Revendications

1. Dispositif semi-conducteur comportant un substrat semi-conducteur prévu avec une région d'un type voulu de conductivité dans laquelle sont introduites des impuretés, une couche conductrice (25, 26, 56) d'un siliciure métallique qui est connecté électriquement à une partie de surface prescrite dudit substrat semi-conducteur et/ou est placée sur une pellicule d'isolement formée sur ledit substrat semi-conducteur et une couche d'isolement (27, 57) d'un oxyde dudit siliciure métallique formée sur ladite couche conductrice, dans lequel ledit siliciure métallique contient des impuretés prescrites dans une quantité ayant pour effet d'augmenter sa vitesse d'oxydation et d'au moins $1 \times 10^{20}$ atomes/cm$^3$, mais insuffisant pour gêner son adhérence sur le substrat lors d'un traitement thermique.

2. Dispositif semi-conducteur selon la revendication 1, caractérisé en ce que ledit siliciure métallique est une composé de silicium et d'au moins un métal choisi dans le groupe comprenant le molybdène, le tungstène, le tantale et le titane.

3. Dispositif semi-conducteur selon la revendication 2, caractérisé en ce que ledit métal est du molybdène, du tungstène ou du tantale.

4. Dispositif semi-conducteur selon la revendication 1, caractérisé en ce que ledit substrat semi-conducteur est en silicium monocristallin et lesdites impuretés que contient le siliciure métallique sont des impuretés de donneur comme de phosphore, d'arsenic ou d'antimoine ou des impuretés d'accepteur comme de bore.

5. Dispositif semi-conducteur selon la revendication 4, caractérisé en ce que la concentration desdites impuretés dans ledit siliciure métallique se situe entre $1 \times 10^{20}$ et $4 \times 10^{21}$ atomes/cm$^3$.

6. Dispositif semi-conducteur selon la revendication 1, caractérisé en ce qu'une couche semi-conductrice polycrystalline est formée sous ladite couche conductrice.

7. Dispositif semi-conducteur selon la revendication 6, caractérisé en ce que ladite couche semi-conductrice polycrystalline est en silicium polycrystallin.

8. Dispositif semi-conducteur selon la revendication 7, caractérisé en ce que ladite couche de silicium polycrystallin a une épaisseur dans la plage de 50 à 300 nm.

21

**0 051 500**

22

9. Dispositif semi-conducteur selon la revendication 1, caractérisé en ce qu'une autre couche conductrice est formée sur ladite couche d'isolement.

Fig. 1

*Fig. 2*

*Fig. 3*

*Fig. 4*

*Fig. 5*

*Fig. 6*

*Fig. 7*

## Fig. 8

## Fig. 9

Fig. 10

Fig. 11

Fig. 12